(19)

Europäisches
Patentamt
European
Patent Office
Office européen
des brevets

(11) **EP 1 209 745 B1**

(12) **EUROPEAN PATENT SPECIFICATION**

(45) Date of publication and mention
of the grant of the patent:
**08.06.2011 Bulletin 2011/23**

(51) Int Cl.:
*H01L 29/739* (2006.01)     *H01L 29/08* (2006.01)
*H01L 27/02* (2006.01)     *H01L 29/10* (2006.01)
*H01L 27/04* (2006.01)

(21) Application number: **02003971.5**

(22) Date of filing: **19.06.1995**

(54) **Vertical MOS semiconductor device**

Vertikales MOS-Halbleiterbauelelement

Dispositif semiconducteur MOS vertical

(84) Designated Contracting States:
**DE FR GB NL**

(30) Priority: **22.06.1994 JP 13974894**

(43) Date of publication of application:
**29.05.2002 Bulletin 2002/22**

(62) Document number(s) of the earlier application(s) in
accordance with Art. 76 EPC:
**95304218.1 / 0 691 687**

(73) Proprietor: **Fuji Electric Systems Co., Ltd.**
**Tokyo 141-0032 (JP)**

(72) Inventors:
• **Yamazaki, Tomoyuki**
**Kawasaki-ku,**
**Kawasaki 210 (JP)**
• **Obinata, Shigeyuki**
**Kawasaki-ku,**
**Kawasaki 210 (JP)**
• **Otsuki, Masahito**
**Kawasaki-ku,**
**Kawasaki 210 (JP)**

• **Momota, Seiji**
**Kawasaki-ku,**
**Kawasaki 210 (JP)**
• **Fujihira, Tatsuhiko**
**Kawasaki-ku,**
**Kawasaki 210 (JP)**

(74) Representative: **Bridge-Butler, Alan James et al**
**Baron Warren Redfern**
**19 South End**
**Kensington**
**London W8 5BU (GB)**

(56) References cited:
**EP-A- 0 557 126     EP-A- 0 625 797**
**EP-A- 0 647 026     DE-A- 4 109 183**
**GB-A- 2 257 297**

• **PATENT ABSTRACTS OF JAPAN vol. 018, no. 066
(E-1501), 3 February 1994 (1994-02-03) & JP 05
283705 A (NIPPONDENSO CO LTD), 29 October
1993 (1993-10-29)**
• **PATENT ABSTRACTS OF JAPAN vol. 018, no. 213
(E-1538), 15 April 1994 (1994-04-15) & JP 06
013618 A (NIPPONDENSO CO LTD), 21 January
1994 (1994-01-21)**

## Description

The present invention relates to power semiconductor devices, and particularly concerns semiconductors having a MOS gate such as are conventionally used in inverters etc.

Insulated gate bipolar transistors (hereinafter referred to as "IGBT") and power MOS field effect transistors (hereinafter referred to as "MOSFET") are voltage driven semiconductor switching elements, and are used widely in power electronics by virtue of their low on-voltage and high switching speed. When a fault such as a surge current at the start of a motor, a load short-circuit, an arm short-circuit, etc. occurs, the switching elements such as IGBTs etc. in the inverter are subjected to a high voltage and large current. The characteristics for evaluating the switching elements in relation to such a heavy electrical burden include the breakdown withstand capability called "short-circuit withstand capability".

Although a protecting circuit for detecting short-circuit faults and for interrupting the power supply is conventionally incorporated in inverters and the like, it takes 10 to 20μsec for the protecting circuit to operate after detecting an overcurrent. Therefore, the IGBTs are required not to break down during this period.

To meet this requirement, an overcurrent protecting means has been adopted recently in high performance IGBT modules in addition to the above described protecting circuit. The overcurrent protecting means detects the overcurrent quickly, and limits and suppresses the IGBT current to below the short-circuit withstand capability of the IGBTs by controlling the gates of the IGBTs based on the overcurrent detection signal before the protecting circuit interrupts the power supply.

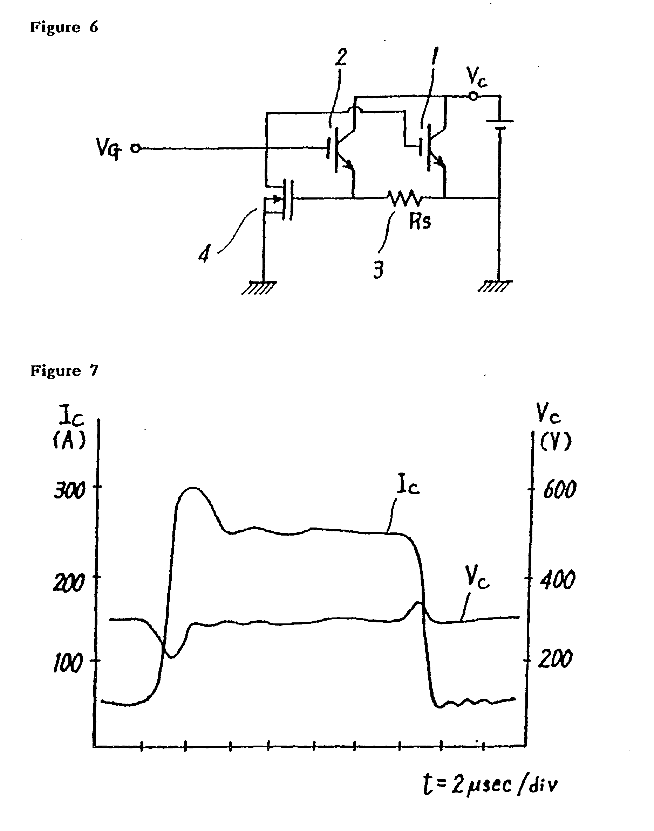

Figure 6 is a circuit diagram showing an example of an overcurrent protecting circuit for the IGBTs (cf. Japanese Laid Open Patent Application number H02-66975). In Figure 6, the reference numeral 1 designates a main element (main IGBT) and 2 designates a subsidiary element for current detection (an IGBT different from the main IGBT) connected in parallel to the main element 1. A current detecting resistor 3 $R_S$ is connected in series with the subsidiary element 2, and a switching element 4 (a MOSFET is shown in the Figure) is connected to the gate driver circuits of the elements 1 and 2. The switching element 4 turns on or off in correspondence to the voltage across the resistor 3.

When the overcurrent caused by a load circuit fault etc. flows through the elements 1 and 2 to boost the voltage across the resistor 3 above the threshold voltage of the switching element 4, the switching element 4 is turned on to lower the gate voltages of the main and subsidiary elements 1 and 2 and thus limits the main current flowing through the main element 1. By setting the resistance of the resistor 3 and the threshold voltage of the switching element 4 respectively at appropriate values, the main current flowing through the main element 1 to be protected is limited to a value within the short-circuit withstand capability.

Figure 7 is a graph showing a main current $I_D$ and a voltage $V_D$ across the main element 1 at a power supply voltage of 400 V while the protecting circuit of Figure 6 acts to limit an overcurrent caused by a load short-circuit fault. In Figure 7, the main element 1 is an IGBT (ratings: 600V, 100A) externally connected to the above described protecting circuit. As can be seen from Figure 7, the main current $I_D$ of the IGBT is limited in several μsec to about 250A corresponding to the short-circuit withstand capability set with respect to the rated current of 100A.

In the above described overcurrent protecting circuit including an IGBT as the subsidiary detecting element 2 and constructed as an external circuit to the IGBT to be protected as the main element 1, it is difficult to secure proportionality between the operations of the elements 1 and 2 because of temperature differences between the chips on which the elements 1 and 2 are individually mounted. To overcome this problem, it has been proposed to form the elements 1 and 2 in a common chip.

For example, US Patent 4,783,690 addresses the problem of the temperature difference between the elements 1 and 2 by assigning some of the cells constituting a main MOSFET to the role of sensing cells for overcurrent detection, and by leading an electrode for the overcurrent detection out from the sensing cells. However, the following problems have been left unsolved by the structure proposed by US Patent 4,783,690:

(1) Since a current leaks through a parasitic lateral MOSFET caused between the main and the sensing cell portions, the actual ratio of the main current and the current for overcurrent detection deviates from the designed value.
(2) Since the main cells and the sensing cell portions are adjoining, a leakage current is caused by minority carriers between the main and sensing cell portions, for example, in the application of the MOSFET to a parasitic diode, an IGBT, etc. to which the minority carriers commit. This leakage current further causes deviation of the actual ratio of the main current and the current for overcurrent detection from the designed value.

To overcome these problems, a method has been proposed in European Patent Application number 95301349.7 for reducing the leakage current by expanding the spacing between the main and the sensing cell portions.

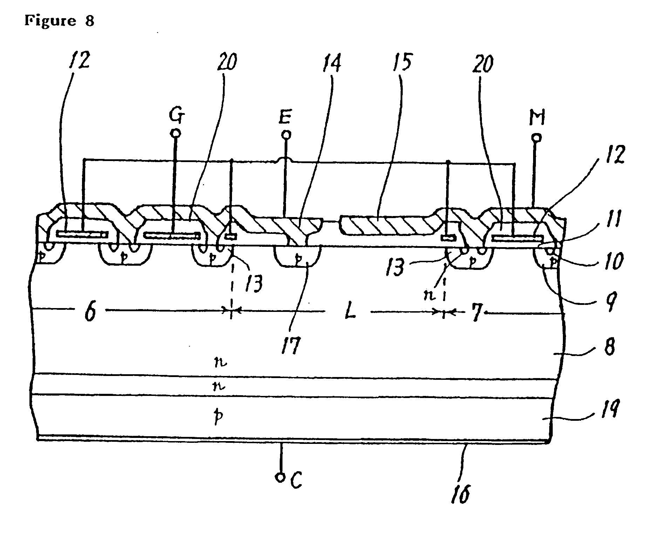

Figure 8 is a sectional view showing a part of an exemplary IGBT device according to the above identified European Patent Application. In Figure 8, a (p) type base region 9 is formed selectively on the surface of an (n) type base layer 8. An (n) type emitter region 10 is formed in the surface of the (p) type base region 9. A gate electrode 12 connected to a gate terminal G is fixed via a gate oxide film 11 to the surface of that portion of the (p) type base region 9 extending between the (n) type base layer 8 and the (n) type emitter region 10. An emitter electrode is fixed via an insulating film 20 to the surface of the device. The emitter electrode is divided into a main emitter electrode 14 for a main cell portion 6 and a sensing emitter electrode 15 for a sensing cell portion 7. The main emitter electrode 14 is connected to a terminal E and the sensing emitter electrode 15 is connected to a terminal M. A collector electrode 16 connected to a terminal C is fixed to the back surface of a semiconductor substrate 19. The main cell portion 6 and the sensing cell portion 7, describing more strictly the nearest parts of adjacent channel regions 13 and 13 of the main and sensing cell portions 6 and 7, are spaced by a spacing L of 100 $\mu$m or more. This distance is long enough to prevent mutual interference between the main and sensing cell portions 6 and 7. Further, a (p) type well 17, to which the emitter electrode 14 of the main cell portion 6 is fixed, is formed between the main and sensing cell portions 6 and 7 to capture the minority carriers (holes).

However, it has been revealed, through research and development of the device proposed in the European Patent Application number 95301349.7, that the pertinent problems still remain unsolved, in that:

(1) The leakage current through the parasitic lateral MOSFET between the main and the sensing cell portions still causes some deviation of the actual ratio of the main current and the current for overcurrent detection from the designed value.

(2) The adjoining main and sensing cell portions cause leakage current by minority carriers between the main and sensing cell portions, for example, in the application of the MOSFET to a parasitic diode, an IGBT, etc. to which the minority carriers commits. This leakage current further causes deviation of the actual ratio of the main current and the current for overcurrent detection from the designed value. In addition, the following problems should not be neglected.

(3) When the main and sensing cell portions are simply spaced wide apart to prevent the leakage current, the wide spacing renders a considerable area of the chip unusable and thus increases the cost of the device.

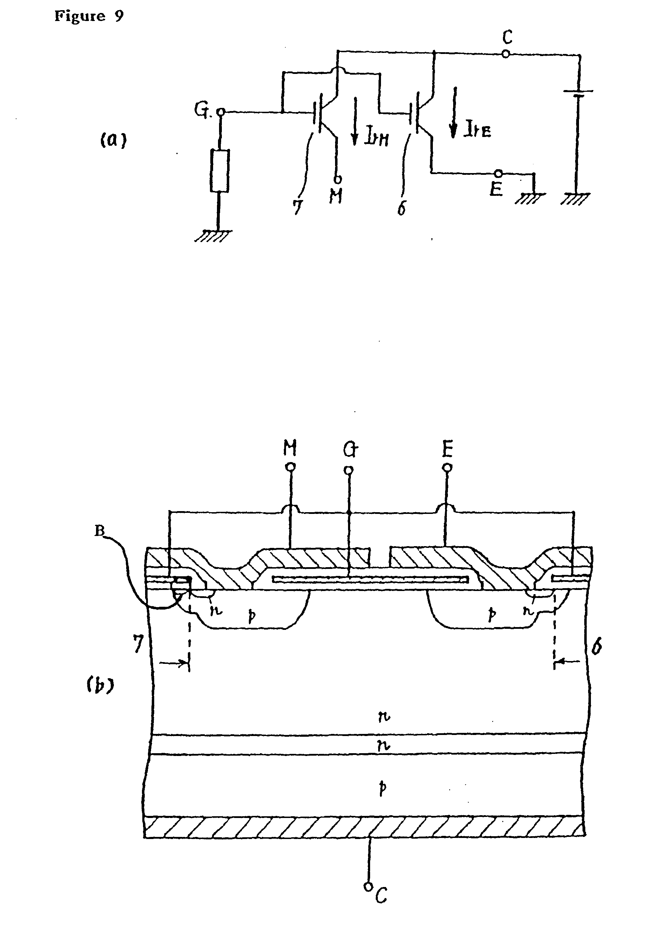

(4) In MOS semiconductor devices having a main cell portion and a sensing cell portion, the sensing cell portion may be broken down by the disconnection of the current detecting resistor when a high voltage is applied between the source and drain or between the collector and emitter when the device is in the off state. This breakdown will be explained with reference to Figures 9(a) and 9(b). Figure 9(a) is a circuit diagram showing an equivalent circuit of the IGBT having the main cell portion 6 and the sensing cell portion 7. In Figure 9(a), a high voltage is applied between the collector C and emitter E of the IGBT, and the emitter terminal M of the sensing cell 7 is in the open state. Figure 9(b) is a sectional view of a part of the IGBT in which the main cell portion 6 and the sensing cell portion 7 adjoin one another. In Figures 9(a) and 9(b), the voltage between the collector and the emitter (between the terminals C and E, and between the terminals C and M) of the main cell portion 6 and the sensing cell portion 7 is determined by the collector potential when the junction leakage currents $I_{rE}$ and $I_{rM}$ flow. Since the emitter electrode E of the main cell portion is grounded while the emitter electrode M of the sensing cell portion is open, the potential of the emitter electrode E rises gradually. In response to this potential rise, the voltage between the emitter terminal M and the gate terminal G of the sensing cell portion rises. When the voltage between the terminals M and G greatly exceeds the withstand voltage of the gate oxide film 11, the gate oxide film 11 is finally broken down in the region indicated by the circle B in Figure 9(b).

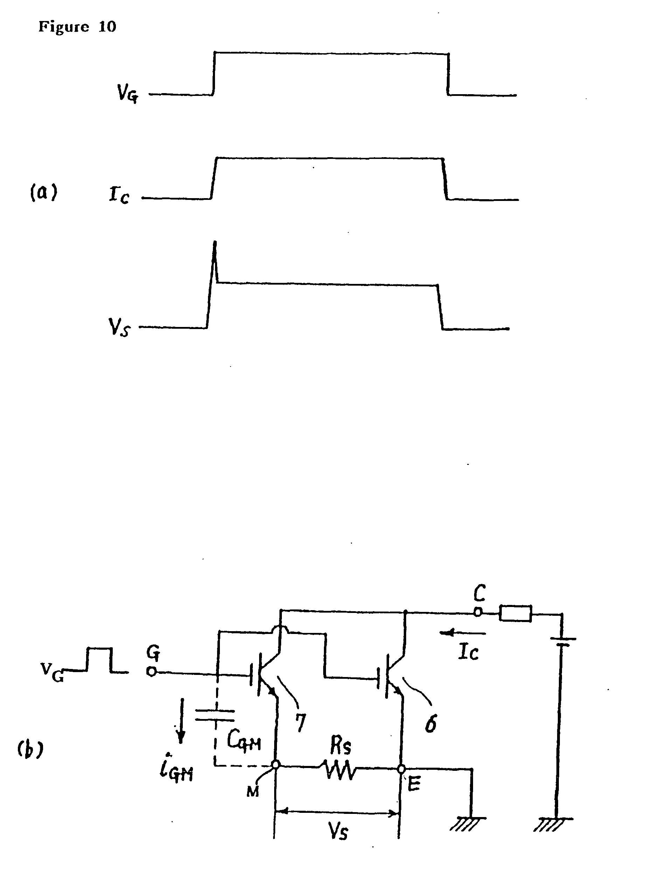

(5) In MOS semiconductor devices having a main cell portion and a sensing cell portion, a spike noise voltage occasionally occurs across the current detecting resistor at the instant when the MOS semiconductor device is turned on. This spike noise voltage will now be explained with reference to Figures 10(a) and 10(b). Figure 10(b) is a circuit diagram showing an equivalent circuit of the IGBT which is connected to a load and turned on and off. In Figure 10(b), a resistor $R_S$ for detecting a current $I_C$ is connected between the emitter terminals M and E of the sensing and main cell portions 7 and 6. The current $I_C$ is measured by detecting a voltage $V_S$ across the resistor $R_S$. Figure 10(a) is a graph of voltage and current against time showing the wave form of the gate voltage $V_G$, the current $I_C$, and the detecting voltage $V_S$ during the operation of the circuit of Figure 10(b). Though the voltage $V_S$ should be proportional to the current $I_C$, a spike noise is caused on the voltage $V_S$ at the turning-on of the IGBT. The spike noise is caused by the capacitance $C_{GM}$ between the gate electrode G and the emitter terminal M of the sensing cell portion 7. In response to the rapid rise of the gate voltage $V_G$ at the turning-on of the IGBT, a displacement current $i_{GM}$ flows through the capacitor $C_{GM}$.

$$i_{GM} = C_{GM} \cdot dV_G/dt \qquad\qquad (1)$$

The current $i_{GM}$ causes the voltage $V_S$ expressed by equation 2 across the resistor $R_S$.

$$V_S = i_{GM}.R_S = C_{GM}.R_S.dV_G/dt \qquad (2)$$

That is, the voltage is caused in proportion to the capacitance $C_{GM}$ between the gate electrode G and the emitter electrode M of the sensing cell portion 7 and the rising rate of the gate voltage $V_G$.

European Patent Application 0 557 126 discloses a power semiconductor device. A large sense voltage is produced by the semiconductor device. The semiconductor device, utilizing current mirror techniques, is comprised of a power MOSFET having a plurality of power cells and a plurality os sense cells formed in a semiconductor epitaxial layer. The large sense voltage is provided by isolating and separating the plurality of power cells from the plurality of sense cells by at least the thickness of the semiconductor epitaxial layer . Isolation can be provided by forming a plurality of inactive cells or an elongated cell between the plurality of power cells and the plurality of sense cells. In addition, high voltage capabilities can be maintained by including a partially active region adjacent the plurality of power cells to provide for good termination.

DE 41 09 183 (corresponding to US 5,097,302) discloses a power MOS-type semiconductor device with a current detection terminal, a first number of main MOSFET elements are connected to one another in parallel, and a second number of detection MOSFET elements are similarly connected to one another. First and second terminals of the main and detection MOSFET elements are commonly connected. A third terminal of one of the detection MOSFET elements is used as the current detection terminal. The current or voltage measured at this detection terminal is substantially proportional to the ratio of the first number to the second number. To this end, the parasitic resistance in the device is increased so as to inhibit a leak current from flowing therethrough. Moreover, the ON resistance of each of the detection MOSFET elements is designed to be lower than that of a main MOSFET element by an amount which is a function of the first number and the detection resistance connected to the current detection terminal.

Patent Abstracts of Japan vol. 018, No. 066 (E-1501), 3 February 1994 and JP 05 283705 A (NIPPONDENSO CO LTD), 29 October 1993 discloses a power DMOS semiconductor device with which the current detection accuracy of DMOS at a detection part can be improved remarkably without extension of a manufacturing process. This is achieved by providing a ring-shaped well region which is formed on the surface of a semiconductor substrate by doping the impurities for a well region, is formed independent of the main well region and the sub-well region wherein the sub-well region is surrounded by the above-mentioned ring-shaped well region through a prescribed interval thus relaxing the electric field on the surface of the substrate. The ring-shaped aperture, which is formed into the shape surrounding the sub-well region by patterning gate electrodes, serves as the mask for formation of the ring-shaped well region when the impurities for well region are doped for formation of the main well region and the sub-well region. As a result, the irregularity in width of a part of the semiconductor substrate between the ring-shaped well region and the sub-well region can be prevented.

Patent Abstracts of Japan vol.018, No. 213 (E-1538), 15 April 1994 and JP 06 013618 A (NIPPONDENSO CO LTD), 21 January 1994 provides a semiconductor device in which the reach-through breakdown voltage of elements in a detection part is increased as compared with a main current part. This is achieved in this semiconductor device by each element being composed of, for example, the cells of DMOS, IGBT and BPT, and one part acts as a detection part and the rest acts as a main current part. These detection part and main current part is provided with a high concentration substrate having a first conductivity type low concentration layer as common electrode in which a second conductivity type main well region and a sub-well region are formed on the surface part of the layer. A first conductivity type surface electrode region which makes the other electrode of the main current part is formed on the surface part of a main well region, and a first conductivity type surface electrode region which makes the other electrode of the detection part is formed on the surface part of the sub-well region. The sub-well region is formed more shallowly than the main well region in accordance with, for example, the narrowing of the width of open grooves of a mask, so that reach-through is brought about first in the main the current part in which the distance between the well region and the substrate is shorter and then is brought about in the detection part in which the distance is longer.

GB 2 257 297 A shows apparatus for sensing current in MOS semiconductor devices and discloses a main transistor formed in a semiconductor layer, the current flowing through the sensing transistor being proportional to the current flowing through the main transistor. Both the main transistor and the sense transistor have a base region, a source region, a gate electrode, and a source electrode. A doped region of the same conductivity type as the base regions is formed in the semiconductor layer between the base regions of the main transistor and the sense transistor. This doped region is in contact with the source electrode of the main transistor. This structure decreases the power loss due to the sense signal current and ensures a linear relationship between the sense signal current and the main current. The transistors may be IGBT or vertical MOSFETS.

None of the earlier disclosures referred to above refer to a problem which arises in MOS semiconductor devices which have a main cell portion and a sensing cell portion. A spike noise voltage occasionally occurs across a current detecting resistor at the instant when the MOS semiconductor device is turned on and it is an object of the present invention to overcome this problem.

According to the present invention there is provided a vertical MOS semiconductor device according to the appended claim 1.

Thus by reducing the overlapping area of the emitter electrode of the sensing cell portion and the gate electrode, or the emitter electrode and gate electrode of the sensing cell portion, so as to reduce the capacitance $C_{gm}$ between the gate and emitter terminals of the sensing cell portion, the displacement current $i_{gm}$ explained with reference to Figure 10 is reduced to lower the spike noise voltage generated when the device turns on.

The present invention will be explained hereinafter with reference to the accompanying drawings, which illustrate the preferred embodiments of the present invention. In the Figures:

Figure 1 is a sectional view showing a first example of an IGBT;

Figure 2 is a top plan view of the first example;

Figure 3 is a sectional view showing a second example of an IGBT;

Figure 4 is a top plan view of the second example;

Figure 5(a) is a top plan view of a part of an embodiment of an IGBT according to present invention;

Figure 5(b) is a sectional view taken along the line A-A' of Figure 5(a) showing an upper part of the embodiment;

Figure 5(c) is a sectional view taken along the line B-B' of Figure 5(a) showing an upper part of the embodiment;

Figure 6 is a circuit diagram showing an exemplary overcurrent protecting circuit for IGBTs;

Figure 7 is a graph showing a main current and a voltage $V_D$ across the main element 1 while the protecting circuit of Figure 6 is limiting an overcurrent;

Figure 8 is a sectional view showing a part of an exemplary IGBT device according to the related application;

Figure 9(a) is a circuit diagram showing an equivalent circuit of the IGBT having a sensing cell, the source electrode terminal of which is open;

Figure 9(b) is a sectional view of a part of the IGBT showing a breakdown point of the IGBT of Figure 9(a);

Figure 10(a) is a graph for explaining the spike noise in the detected voltage $V_S$; and

Figure 10(b) is a circuit diagram showing an equivalent circuit of the IGBT for explaining the cause of the spike noise in the detected voltage $V_S$.

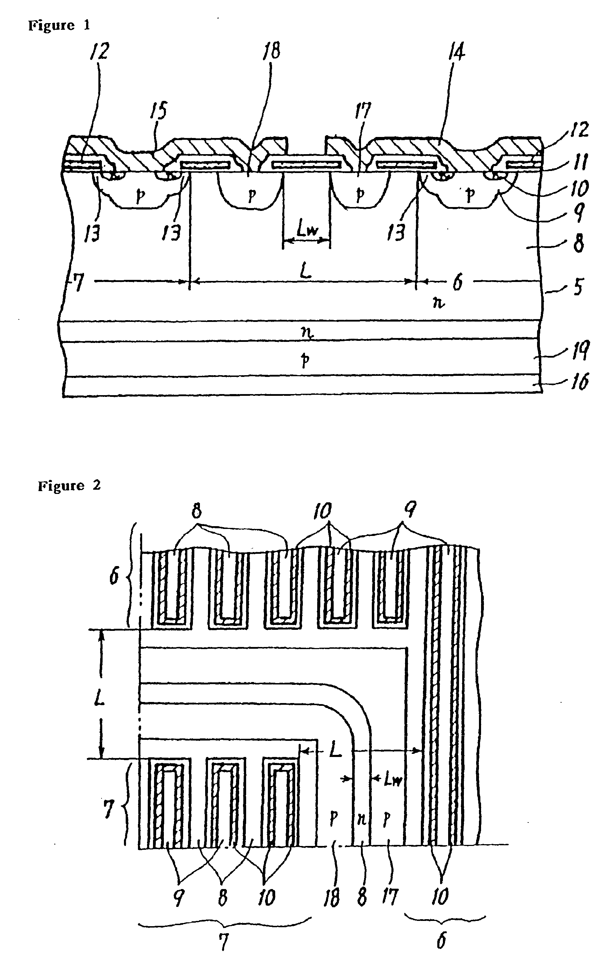

Referring now to the drawings, Figure 1 is a sectional view showing a first example of an IGBT. In Figure 1, the boundary region between the main cell portion 6 and the sensing cell portion 7 for current detection is shown. In Figure 1, very many cells are integrated in parallel connection with each other as the switching units on a semiconductor substrate 5. The main cell portion 6 is illustrated on the right hand side of the Figure, and the sensing cell portion on the left hand side. In Figure 1, a (p) type base region 9 is formed selectively in the surface of an (n) type base layer 8. An (n) type emitter region 10 is formed in the surface of the (p) type base region 9. A gate electrode 12 is fixed via a gate oxide film 11 to the surface of a channel region 13 formed in the surface layer in the portion of the (p) type base region 9 extending between the (n) type base layer 8 and the (n) type emitter region 10. An emitter electrode 14, 15 which contacts commonly with the surfaces of the (n) type emitter region 10 and the (p) type base region 9 is fixed to the surface of the device. The emitter electrode is divided into a main emitter electrode 14 for the main cell portion 6 and a sensing emitter electrode 15 for a sensing cell portion 7. A collector electrode 16 is fixed to the back surface of the semiconductor substrate 5. The main cell portion 6 and the sensing cell portion 7, describing more strictly the nearest channel regions 13 and 13 of the main and sensing cell portions 6 and 7, are spaced by a distance L of $100\mu m$ or more, to prevent mutual interference between the main and sensing cell portions 6 and 7 considering the diffusion length of the electrons supplied from the MOSFET and the minority carriers injected from a (p) type collector layer 19 to the (n) type base layer 8. A (p) type well 17 connected to the main emitter electrode 14 of the main cell portion and a (p) type well 18 connected to the sensing emitter electrode 15 of the sensing cell portion are formed between the main and sensing cell portions 6 and 7, to capture the minority carriers (holes in this example). The wells 17 and 18 are spaced by a distance $L_W$ of $20\mu m$ or less. The spacing $L_W$ is determined as follows: when the specific resistance of the (n) type base layer 8 is $50\Omega cm$, the width of the depletion layer expanding under the applied voltage of 20 V is $20\mu m$. If the spacing $L_W$ is set at $20\mu m$ or less, the junction leakage current $I_{rM}$ of the sensing cell portion flows to the main cell side at the applied voltage of more than 20 V. Therefore, the potential of the sensing emitter electrode 15 is not boosted any more, and the gate oxide film 11 is prevented from breakdown. If the spacing $L_W$ is to narrow, the separation effect between the main and sensing cell portions 6 and 7 is insufficient. Thus, 5 to $20\mu m$ is appropriate for the spacing $L_W$.

Figure 2 is a top plan view of the first example in which the gate oxide film 11, the main and sensing emitter electrodes 14, 15 and their upper structure of Figure 1 are omitted. In Figure 2, the sensing cell portion 7 occupies the lower left part of the Figure. The (p) type well 18 for capturing the minority carriers is formed in a ring shape surrounding the sensing cell portion 7. The main cell portion 6 is located on the upper and right hand sides of the Figure.

In the structure described above, (p) type well 18, electrically contacted with the sensing emitter electrode 15 captures minority carriers diffusing out from the sensing cell portion 7 to the main cell portion 6, and (p) type well 17, electrically contacted with the main emitter electrode 14 captures the minority carriers diffusing from the main cell portion 6 toward the sensing cell portion 7. Thus, the above described structure facilitates reducing greatly the leakage current between the main and sensing cell portions 6 and 7 caused by minority carriers. In association with this leakage current reduction, the spacing between the main and sensing cell portions 6 and 7 may be shortened to reduce the overall chip area. The efficiency with which the minority carriers are captured is improved by surrounding the sensing cell portion 7 with the ring shaped (p) type wells 17 and 18.

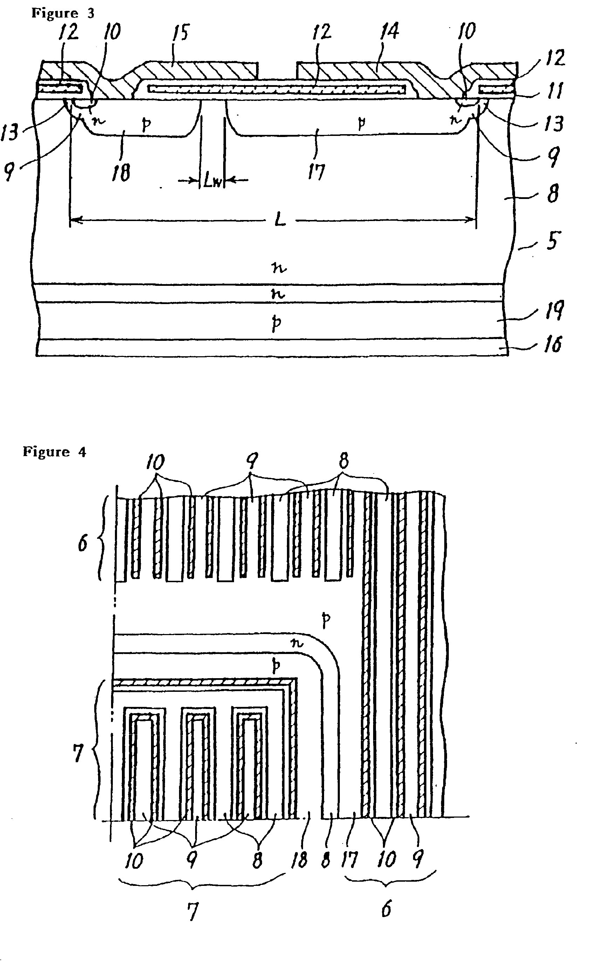

Figure 3 is a sectional view showing the second example of an IGBT. In Figure 3, the boundary region between the main cell portion 6 and the sensing cell portion 7 for current detection is shown. The main cell portion 6 is shown on the right hand side of the Figure and the sensing cell portion 7 on the left hand side. In Figure 3, a (p) type base region 9 is formed selectively in the surface of an (n) type base layer 8. An (n) type emitter region 10 is formed in the surface of the (p) type base region 9. A gate electrode 12, a main emitter electrode 14, a sensing emitter electrode 15, and a collector electrode 16 are disposed in the same manner as in the first embodiment of Figure 1. However, the (p) type well 17 for capturing the minority carriers (in this case, holes) is connected with the (p) type base region 9 of the main cell portion 6 and the (p) type well 18 is connected with the (p) type base region 9 of the sensing cell portion 7. The spacing between the main and sensing cell portions 6 and 7 is measured between the nearest neighbouring channel regions 13 and 13. The main and sensing cell portions 6 and 7 are spaced by a distance L of $100\mu m$ or more, thus preventing any mutual interference of the main and sensing cell portions 6 and 7 considering the diffusion length of the electrons supplied from the MOSFET and the minority carriers injected from the (p) type collector layer 19 to the base layer 8. Between the main and sensing cell portions, the spacing $L_W$ between the (p) type well 17, connected to the main emitter electrode 14 of the main cell portion, for capturing the minority carriers (in this case, holes) and the (p) type well 18, connected to the sensing emitter electrode 15 of the sensing cell portion, is set at $20\mu m$ or less.

Figure 4 is a top plan view of the second example in which the gate oxide film 11, the emitter electrodes 14, 15 and their upper structure of Figure 3 are omitted. In Figure 4, the sensing cell portion 7 occupies the lower left part of the Figure, and the main cell portion 6 the other part.

In the structure described above in Figure 3, the (p) type well 18, in electrical contact with the sensing emitter electrode 15 of the sensing cell portion, captures the minority carriers diffusing from the sensing cell portion 7 toward the main cell portion 6, and (p) type well 17, in electrical contact with the main emitter electrode 14 of the main cell portion, captures the minority carriers diffusing from the main cell portion 6 toward the sensing cell portion 7. Thus, the structure described in Figure 3 facilitates reducing greatly the leakage current between the main and sensing cell portions 6 and 7 caused by the minority carriers. In correspondence with this leakage current reduction, the spacing between the main and sensing cell portions 6 and 7 may be shortened to reduce the chip area. Further, as in the previous example, the efficiency with which the minority carriers are captured is improved by completely surrounding the sensing cell portion 7 with the ring shaped (p) type wells 17 and 18.

In the examples of Figures 1 and 3, the spacing between the (p) type well 17, connected to the main emitter electrode 14 of the main cell portion, and the (p) type well 18, connected with the sensing emitter electrode 15 of the sensing cell portion, is short enough for the depletion layer to spread from the sensing cell portion 7 to the main cell portion 6 to avoid the breakdown of the gate insulation film 10 even when a voltage is applied to the collector electrode 16 under the open state of the emitter electrode 15 of the sensing cell portion.

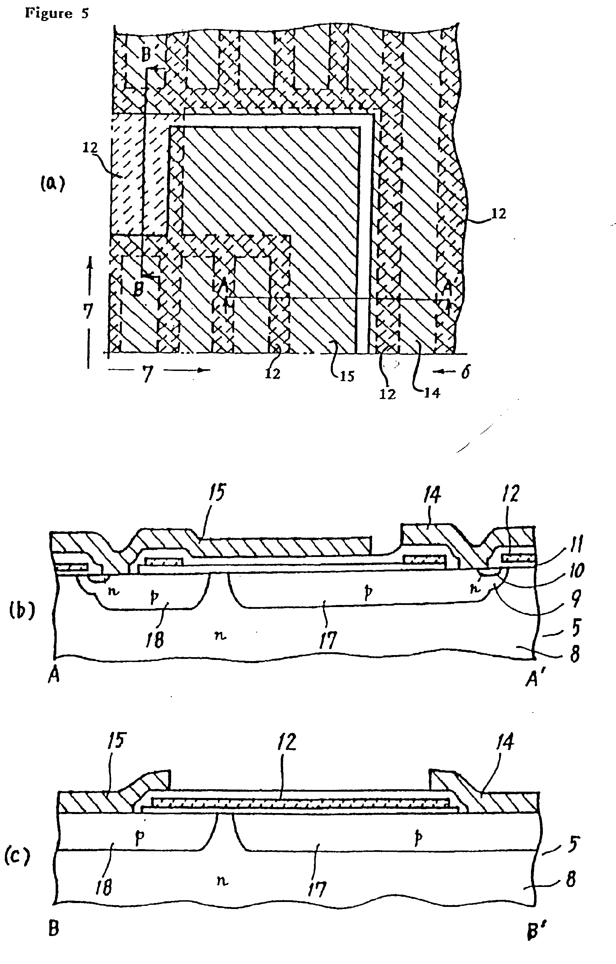

Figure 5(a) is a top plan view of a part of an embodiment of an IGBT according to present invention. Figure 5(b) is sectional view taken along the line A-A' of Figure 5(a) showing an upper part of the embodiment. Figure 5(c) is a sectional view taken along the line B-B' of Figure 5(a) showing an upper part of the embodiment. In Figure 5(a), the sensing cell portion 7 occupies the lower left part of the Figure, and the main cell portion 6 is located on the upper and right hand sides of the Figure. In Figure 5(a), a gate electrode 12 is shown by the broken line hatching, an emitter electrode 15 of the sensing cell portion by the narrowly spaced solid line hatching, and an emitter electrode 14 of the main cell portion by the widely spaced solid line hatching. In the separating region by which sensing cell portion 7 and the main cell portion 6 are spaced, the gate electrode 12 is not formed under the extension of the emitter electrode 15 as shown in Figure 5(b). This allows the overlapping area of the electrodes 12 and 15 to be reduced as much as possible. Since the sensing cell portion 7 is formed with an island shape so as to be surrounded by the wells 17, 18 for capturing the minority carriers, the gate electrode should be connected to some point in the sensing cell portion 7. The gate electrode 12 is thus extended, as shown in Figure 5(c), over the separating region while the extension of the emitter electrode 15 of the sensing cell portion 7 is shortened at that part of the separating region, as seen in the B-B' section, so as to reduce the overlapping area of the electrodes 12 and 15. Thus, the capacitance $C_{GM}$ between the gate electrode 12 and the emitter electrode 15 is reduced. Therefore, the spike noise voltage which the displacement current causes across the current detecting resistor at the turning-on of the IGBT is reduced.

Though the present invention has been explained by way of examples of the IGBT, it is emphasised that the present invention is applicable to all vertical MOS semiconductor devices such as MOSFETs, MOS control thyristors (MCT), etc.

As explained above, the present invention facilitates maintaining the ratio of the main and detecting currents at a constant value under any circumstance. The present invention also facilitates avoiding the breakdown of the device in the open state of the emitter electrode of the sensing cell portion or at the instant of turning-on the device.

**Claims**

1. A vertical MOS semiconductor device comprises a main cell portion (6) having a number of switching cells spaced apart by a separating region (L) from a sensing cell portion (7) for detecting a current of the main cell portion (6), each of the cell portions further comprising a semiconductor layer (5) of a first conductivity type, a base region of a second conductivity type formed selectively on a first surface of the semiconductor layer (5), an emitter region (10) of a first conductivity type formed selectively in the surface of the base region (9), a gate electrode (12) fixed via a gate oxide film to that portion of the base region (9) extending between the semiconductor layer (5) and the emitter region (10), and an emitter electrode (15) contacting in common with the surface of the base region (9) and the emitter region (10), a first well (18) of the second conductivity type formed between the main and sensing cell portions, the first well being connected with the emitter electrode of the sensing cell portion, and directly connected with the base region (9) of the sensing cell portion, and a second well (17) of the second conductivity type formed between the main and sensing cell portions, the second well being connected with the emitter electrode of the main cell portion and directly connected with the base region (9) of the main cell portion, the sensing cell portion formed in an island shape surrounded by the first and second wells, and in the separating region (L) only part of the area of the gate electrode (12) is located beneath the emitter electrode (15) of the sensing cell portion (7) and only part of the area of the emitter electrode (15) of the sensing cell (7) is located above the gate electrode (12), so that the area of overlap between the gate electrode (12) and the emitter electrode (15) in the separating region (L) is reduced when compared to if they both fully overlapped each other, the gate electrode (12) extends over the separating region (L) from the base region (9) of the main cell portion (6) to the base region (9) of the sensing cell portion (7), and the emitter electrode (15) at the sensing cell portion (7) extends over the first and second wells, said extension of the emitter electrode is formed shorter at the extension of the gate electrode (12) over the separating region (L) than at the part of the separating region where the extension of the gate electrode is not formed.

**Patentansprüche**

1. Vertikales MOS-Halbleiterbauelement mit einem Hauptzellenteil (6) mit einer Anzahl von Schaltzellen, der durch einen Trennbereich (L) von einem Erfassungszellenteil (7) zum Detektieren eines Stroms des Hauptzellenteils (6) beabstandet ist, wobei jeder der Zellenteile ferner eine Halbleiterschicht (5) eines ersten Leitfähigkeitstyps, einen Basisbereich eines zweiten Leitfähigkeitstyps, der selektiv auf einer ersten Oberfläche der Halbleiterschicht (5) ausgebildet ist, einen Emitterbereich (10) eines ersten Leitfähigkeitstyps, der selektiv in der Oberfläche des Basisbereichs (9) ausgebildet ist, eine Gateelektrode (12), die über eine Gateoxidschicht an jenem Teil des Basisbereichs (9) befestigt ist, der sich zwischen der Halbleiterschicht (5) und dem Emitterbereich (10) erstreckt, und eine Emitterelektrode (15), die gemeinsam mit der Oberfläche des Basisbereichs (9) und des Emitterbereichs (10) in Kontakt steht, umfasst, wobei eine erste Wanne (18) des zweiten Leitfähigkeitstyps zwischen dem Haupt- und dem Erfassungszellenteil ausgebildet ist, wobei die erste Wanne mit der Emitterelektrode des Erfassungszellenteils verbunden ist und direkt mit dem Basisbereich (9) des Erfassungszellenteils verbunden ist, und eine zweite Wanne (17) des zweiten Leitfähigkeitstyps zwischen dem Haupt- und dem Erfassungszellenteil ausgebildet ist, wobei die zweite Wanne mit der Emitterelektrode des Hauptzellenteils verbunden ist und direkt mit dem Basisbereich (9) des Hauptzellenteils verbunden ist, wobei der Erfassungszellenteil in einer Inselform ausgebildet ist, die von der ersten und der zweiten Wanne umgeben ist, und im Trennbereich (L) nur ein Teil der Fläche der Gateelektrode (12) unter der Emitterelektrode (15) des Erfassungszellenteils (7) liegt und nur ein Teil der Fläche der Emitterelektrode (15) der Erfassungszelle (7) über der Gateelektrode (12) liegt, so dass die Fläche der Überlappung zwischen der Gateelektrode (12) und der Emitterelektrode (15) im Trennbereich (L) im Vergleich dazu, wenn sie beide vollständig miteinander überlappt sind, verringert ist, die Gateelektrode (12) sich über den Trennbereich (L) vom Basisbereich (9) des Hauptzellenteils (6) zum Basisbereich (9) des Erfassungszellenteils (7) erstreckt, und die Emitterelektrode (15) des Erfassungszellenteils (1) sich über die erste und die zweite Wanne erstreckt, wobei die Ausdehnung der Emitterelektrode an der Ausdehnung der Gateelektrode (12) über dem Trennberiech (L) kürzer ausgebildet ist als am Teil des Trennbereichs, wo die Ausdehnung der Gateelektrode nicht ausgebildet ist.

**EP 1 209 745 B1**

## Revendications

1. Composant semi-conducteur MOS vertical, comprenant une partie à cellules principales (6) ayant un certain nombre de cellules de commutation espacées les unes des autres par une région séparatrice (L) depuis une partie à cellules détectrices (7) servant à détecter un courant de la partie à cellules principales (6), chacune des parties à cellules comportant en outre une couche semi-conductrice (5) d'un premier type de conductivité formée d'une manière sélective sur une première surface de la couche semi-conductrice (5), une région formant émetteur (10) d'un premier type de conductivité formée d'une manière sélective dans la surface de la région formant base (9), une électrode de grille (12) fixée par l'intermédiaire d'un film d'oxyde de grille à la partie de la région formant base (9) qui s'étend entre la couche semi-conductrice (5) et la région formant émetteur (10), et une électrode d'émetteur (15) au contact, en commun, de la surface de la région formant base (9) et de la région formant émetteur (10), un premier puits (18) du second type de conductivité formé entre les parties à cellules principales et détectrices, le premier puits étant connecté à l'électrode d'émetteur de la partie à cellules détectrices et directement connecté à la région formant base (9) de la partie à cellules détectrices, et un second puits (17) du second type de conductivité formé entre les parties à cellules principales et détectrices, le second puits étant connecté à l'électrode d'émetteur de la partie à cellules principales et directement connecté à la région formant base (9) de la partie à cellules principales, la partie à cellules détectrices étant réalisée sous la forme d'un îlot entouré par les premier et second puits, et dans la région séparatrice (L) seule une partie de la surface de l'électrode de grille (12) est située sous l'électrode d'émetteur (15) de la partie à cellules détectrices (7) et seule une partie de la surface de l'électrode d'émetteur (15) de la partie à cellules détectrices (7) est située au-dessus de l'électrode de grille (12), si bien que la zone de chevauchement entre l'électrode de grille (12) et l'électrode d'émetteur (15) dans la région séparatrice (L) est réduite en comparaison du cas où elles se chevauchent entièrement l'une l'autre, l'électrode de grille (12) se prolongeant sur la région séparatrice (L) depuis la région formant base (9) de la partie à cellules principales (6) jusqu'à la région de base (9) de la partie à cellules détectrices (7), et l'électrode d'émetteur (15) de la partie à cellules détectrices (7) s'étendant sur les premier et second puits, ledit prolongement de l'électrode d'émetteur étant beaucoup plus court au niveau du prolongement de l'électrode de grille (12) sur la région séparatrice (L) qu'au niveau de la partie de la région séparatrice où n'est pas formé le prolongement de l'électrode de grille.

Figure 1

Figure 2

Figure 3

Figure 4

Figure 5

(a)

(b)

(c)

Figure 6

Figure 7

$t = 2 \mu sec / div$

Figure 8

Figure 9

(a)

(b)

Figure 10

(a)

$V_G$

$I_c$

$V_s$

(b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0266975 B
- US 4783690 A
- EP 95301349 A
- EP 0557126 A
- DE 4109183

- US 5097302 A
- JP 5283705 A
- JP 6013618 A
- GB 2257297 A

**Non-patent literature cited in the description**

- *Patent Abstracts of Japan,* 03 February 1994, vol. 018 (066), E-1501

- *Patent Abstracts of Japan,* 15 April 1994, vol. 018 (213), E-1538